## Europäisches Patentamt

## European Patent Office

## Office européen des brevets

(19)

(11) Veröffentlichungsnummer: **0 198 150**
A1

(12) # EUROPÄISCHE PATENTANMELDUNG

(21) Anmeldenummer: **86100494.3**

(22) Anmeldetag: **16.01.86**

(51) Int. Cl.⁴: **C 03 C 8/14, H 01 C 7/00**

(30) Priorität: **06.02.85 DE 3503929**

(43) Veröffentlichungstag der Anmeldung: **22.10.86**
**Patentblatt 86/43**

(84) Benannte Vertragsstaaten: **AT BE CH DE FR GB IT LI LU NL SE**

(71) Anmelder: **Reimbold & Strick GmbH & Co. KG, Kunftstrasse 4, D-5000 Köln 91 (DE)**

(72) Erfinder: **Cremer, Wilhelm, Dipl.-Ing. (FH), Vorhelmer Weg 99, D-4730 Ahlen (DE)**
Erfinder: **Sölla, Jakob, Württemberger Weg 2, D-5047 Wesseling (DE)**

(74) Vertreter: **Keller, Johanna Carola et al, Deichmannhaus am Hauptbahnhof, D-5000 Köln 1 (DE)**

(54) **Keramische Zusammensetzungen und ihre Verwendung.**

(57) Die Erfindung betrifft Zusammensetzungen und ihre Verwendung zur Herstellung von Leitern, nämlich leitenden, eingestellte und reproduzierbare Widerstandswerte aufweisenden, gegebenenfalls pulverisierbaren Körpern bzw. Schichten auf elektrisch isolierenden Werkstoffen als Träger. Die Zusammensetzungen bestehen im wesentlichen aus einer gemahlenen Glasfritte einerseits und Siliciumteilchen andererseits, und sie können, sofern dies im Rahmen ihrer Verwendung zweckmäßig bzw. notwendig erscheint, entweder als solche unmittelbar oder angeteigt in einem verdampfbaren flüssigen Dispergiermittel suspendiert oder pastenförmig verwendet werden.

## Keramische Zusammensetzungen und ihre Verwendung

Die Erfindung betrifft keramische Zusammensetzungen und ihre Verwendung zur Herstellung von metallkeramischen Leitern, nämlich leitenden, eingestellte und reproduzierbare Widerstandswerte aufweisenden Körpern, die gegebenenfalls pulverisiert und als leitendes Pulver in einer Matrix weiterverwendet werden können, bzw. Schichten auf elektrisch isolierenden Werkstoffen als Träger, beispielsweise auf Glas, Keramik und/oder isolierten Metalloberflächen. Die keramischen Zusammensetzungen bestehen im wesentlichen aus einer gemahlenen Glasfritte einerseits und Metallteilchen andererseits, und sie können, sofern dies im Rahmen ihrer Verwendung zweckmässig bzw. notwendig erscheint, entweder als solche unmittelbar eingesetzt oder in einem verdampfbaren flüssigen Dispergiermittel suspendiert oder pastenförmig angeteigt werden.

Metallkeramische Leiter sind in erster Linie auf dem Gebiet der sog. Dickschichttechnik seit langem bekannt. Hier werden auf einen isolierenden Träger beispielsweise mit Hilfe der Siebdrucktechnik Leiterbahnen, Widerstände, Induktivitäten und Kondensatoren aufgebracht, um elektronische Schaltungen zu fertigen. Die zur Anwendung kommenden metallkeramischen Leiter bestehen im wesentlichen aus einem sehr feindispersen Metallpulver aus vorzugsweise Edelmetallen und Edelmetall-Legierungen, insbesondere aus Gold oder Edelmetallen der VIII. Gruppe des Periodischen Systems, und dieses Metallpulver ist mit einer pulverisierten, im Handel erhältlichen Glasfritte vermischt und wird mit einem flüssigen organischen Bindemittel zu einer Paste angeteigt. Diese Paste wird dann meist im Siebdruckverfahren auf den Träger aufgebracht und bei Temperaturen im Bereich von 600 ° bis 900 °C eingebrannt. Bei diesem Brennvorgang schmilzt die Glasfritte und verbindet die Metallteilchen untereinander und mit dem Träger in einem Glasfluß. Die hierbei gebildeten Schichten sind elektrisch leitfähig, und es können Leitwerte bis zu 30 Milliohm /cm² erhalten werden.

Es ist auch schon versucht worden, als leitfähige feindisperse Metalle Kupfer und auch Nickel, das letztgenannte auch in Kombination mit geringen Anteilen an Eisen (DE-AS 11 46 991), einzusetzen, doch sind in diesen Fällen unerwünschte Begleiterscheinungen infolge der leichten Oxidierbarkeit dieser Metalle unvermeidlich, die nicht nur beim Brennen sondern auch beim späteren Gebrauch zu Störungen Anlaß geben, insbesondere bezüglich der mangelnden Langzeitstabilität der erhaltenen Leitwerte.

Die Verwendung dieser aus der Dickschichttechnik bekannten metallkeramischen Leiter als Heizleiter bei entsprechend hoher Strombelastung ist nicht nur unzweckmäßig, sondern insbesondere auch nicht sinnvoll; denn zum einen sind die erreichbaren Temperaturen schon durch den Erweichungspunkt der als Bindemittel eingesetzten Glasfritte begrenzt und zum anderen sind infolge der erheblichen Unterschiede der thermischen Ausdehnungskoeffizienten des isolierenden Trägermaterials, der Glasfritte und insbesondere der leitenden Metallteilchen beim Aufheizen mechanische Spannungen und Rißbildung im metallkeramischen Leiter bzw. im Verbund von Leiter- und Trägermaterial nicht auszuschließen. Hinzukommt, daß die beschriebenen Leiterwerkstoffe auf einen Träger aus isolierenden Werkstoffen angewiesen und nicht dazu geeignet sind, einen frei tragenden Leiter beispielsweise in Form eines Stabes zu bilden. Außerdem handelt es sich bei den oxidationsbeständigen edelmetallhaltigen Metallteilchen um sehr kostspielige Werkstoffe, deren Einsatz nur im Rahmen des niedrigen Verbrauchs bei der Herstellung miniaturisierter elektronischer Dickschichtschaltungen vertretbar ist, während dieser Kostenfaktor bei anderen Verwendungen eine bedeutende Rolle spielt.

Der Erfindung lag die Aufgabe zugrunde, keramische Zusammensetzungen verfügbar zu machen, die die meisten der oben geschilderten Nachteile der bisher zur Anwendung gekommenen bekannten Zusammensetzungen nicht aufweisen und Materialien darstellen, aus denen leitende, eingestellte und insbesondere auch reproduzierbare Widerstandswerte aufweisende, gegebenenfalls pulverisierbare und dann weiter formbare Körper, außerdem aber auch Schichten auf elektrisch isolierenden Werkstoffen mit ebenfalls eingestellten, reproduzierbaren Widerstandswerten hergestellt werden können.

Die Lösung dieser Aufgabe sind keramische Zusammensetzungen der eingangs beschriebenen, aus Glasfritte und Metallteilchen bestehenden Art, die dadurch gekennzeichnet sind, daß die Glasfritte einen Gehalt an für die Dotierung von Silicium geeigneten Elementen in Mengen von 2 bis 30 Gew.-%, berechnet als Oxide und bezogen auf die in der Fritte insgesamt vorliegenden Oxide, aufweist, und daß die Metallteilchen aus technisch reinem Siliciumpulver bestehen.

Als Glasfritten können die üblichen, in bezug auf ihre Zusammensetzung dem Fachmann geläufigen Glasfritten eingesetzt werden, beispielsweise solche, die $SiO_2$, $Al_2O_3$, Alkalioxide, Erdalkalioxide und/oder andere niedrig schmelzende Oxide enthalten.

Als dotierende Elemente eignen sich insbesondere Bor und Phosphor, doch können in der Glasfritte auch andere Si-dotierende Elemente, beispielsweise Arsen und Kombinationen derartiger Elemente zur Anwendung kommen.

Im Prinzip bestehen die keramischen Zusammensetzungen erfindungsgemäß also ebenfalls aus einem fein gemahlenen elektrisch leitfähigen Material, das mit Hilfe einer bei erhöhten Temperaturen schmelzenden pulverförmigen Glasfritte zu einer kompakten Schicht auf einem Träger oder aber unmittelbar zu einem festen Körper zusammengesintert werden kann, der seinerseits wieder pulverisiert und als leitfähiges Pulver in einer Matrix, beispielsweise in einem Lacksystem Verwendung finden kann. Im Gegensatz zu den bisher bekannten Werkstoffen zur Gewinnung von metallkeramischen Leitern handelt es sich bei dem technisch reinen, also metallurgisch erhaltenen Siliciumpulver um einen sehr kostengünstig erhältlichen Werkstoff, der sich gegenüber den bisher schon verwendeten unedleren Metallen vor allem dadurch auszeichnet, daß er auch bei hohen Temperaturen durch sein eigenes Oxid vor weiterer Oxidation wirksam geschützt ist.

Ein weiterer wesentlicher Vorteil des Siliciums gegenüber den bisher verwendeten metallischen Werkstoffen ist sein mit dem der einbettenden Glasfritte weitaus besser übereinstimmender thermischer Ausdehnungskoeffizient, durch den bei thermischer Wechselbelastung Beschädigungen des kompakten oder schichtförmigen Leiters infolge thermischer Spannungsrisse verhindert werden.

0198150

Andererseits handelt es sich bei Silicium aber um einen Werkstoff mit Halbleitercharakter, so daß der Fachmann an sich hätte erwarten müssen, daß insbesondere auch unter Berücksichtigung der stark schwankenden Reinheit des metallurgisch gewonnenen Siliciumpulvers keine ausreichende und vor allem reproduzierbar eingestellte Leitfähigkeit erreicht werden könnte. Überraschenderweise hat sich erfindungsgemäß aber gezeigt, daß dieses angestrebte Ziel dann erreicht werden kann, wenn über die Glasfritte Elemente in die keramischen Zusammensetzungen eingeführt werden, die aus der Halbleitertechnik als wirksame Dotierungsstoffe für Silicium bekannt sind, wie u.a. Arsen, Phosphor und insbesondere Bor.

Wie bereits erwähnt, beträgt der Gehalt an diesen Dotierungselementen 2 bis 30 Gew.-%, berechnet als Oxide und bezogen auf die in der Glasfritte insgesamt vorliegenden Oxide, d.h. bei der Anwendung der keramischen Zusammensetzungen zur Herstellung metallkeramischer Leiter wird sehr viel Dotierungselement in das Silicium eingebaut, das auf Grund seiner metallurgischen Herkunft ohnehin bereits große Mengen an Fremdatomen enthält. Infolge der damit verbundenen Exzess-Dotierung verliert das Silicium den Charakter eines Halbleiters und erhält die metallische Leitfähigkeit, die in Verbindung mit der einbettenden Glasfritte die Verwendung der beschriebenen keramischen Zusammensetzungen als Werkstoff für leitende Körper und leitende Schichten mit eingestellten, reproduzierbaren Widerstandwerten ermöglicht.

Als keramische Zusammensetzungen gemäß der Erfindung haben sich solche Zusammensetzungen besonders günstig erwiesen, die aus 20 bis 50 Gew.-% Glasfritte und Rest Siliciumpulver bestehen, jeweils bezogen auf die Gesamtfeststoffe.

Eine Zerkleinerung des Siliciums auf die in der Dickschichttechnik üblichen Feinheiten des Leitmetall-Pulvers im μm-Bereich ist erfindungsgemäß nicht erforderlich, vielmehr kann das Siliciumpulver in einer gewöhnlichen Mahlfraktion mit einem Kornspektrum von 0 bis 120 μm verwendet werden.

Es ist zweckmäßig, in den keramischen Zusammensetzungen gemäß der Erfindung zusätzlich Schwebemittel mit zu verwenden; denn durch deren Zusatz kann die Viskosität der Glasfritte günstig beeinflußt und gesteuert werden. Auf Kosten des Siliciumpulvers können die keramischen Zusammensetzungen zusätzlich bis zu 40 Gew.-%, vorzugsweise 5 bis 30 Gew.-%, eines die Viskosität der Glasfritte steuernden Schwebemittels aufweisen. Keramische Zusammensetzungen gemäß der Erfindung enthalten beispielsweise 10 bis 25 Gew.-% Schwebemittel neben 30 Gew.-% borhaltiger Glasfritte und 45 bis 60 Gew.-% Siliciumpulver oder 30 bis 40 Gew.-% Schwebemittel neben 30 Gew.-% borhaltiger Glasfritte und Rest Siliciumpulver. Als Schwebemittel können beispielsweise Bentonite, Tone, Gelatine und pyrogene Kieselsäure (Aerosil) eingesetzt werden, wobei Tone bevorzugt Verwendung finden.

Aus den beschriebenen keramischen Zusammensetzungen gemäß der Erfindung können stabförmige Leiter hergestellt werden, indem das Ausgangsgemisch in einen rohr- oder wannenartig geformten Tiegel gefüllt, in diesem zu einem Körper gesintert und nach dem Abkühlen aus dem Tiegel gelöst wird. Diese Leiter sind pulverisierbar und als Pulver in einer Matrix eingebettet beispielsweise als leitfähiger Lack einsetzbar.

Leitfähige Schichten auf einem isolierenden Trägermaterial werden durch Auftragen der keramischen Zusammensetzung auf den beispielsweise bereits gebrannten keramischen Träger und anschließendes Sintern hergestellt. Besonders wirtschaftlich ist in diesem Zusammenhang eine Verfahrensvariante, bei der in einem einzigen Brennvorgang der als keramischer Träger eingesetzte Rohscherben gebrannt, die keramische Zusammensetzung gemäß der Erfindung gesintert und hierbei das für die Leitfähigkeit der Schicht verantwortliche Siliciumpulver mit dem Dotierungselement aus der Glasfritte dotiert wird.

Um das Aufbringen der keramischen Zusammensetzungen auf die Trägermaterialien zu vereinfachen und auch spezielle Auftragsverfahren, wie beispielsweise Siebdrucktechnik, Gießtechnik, Spritztechnik oder das Aufbringen mittels Abziehbildern zu ermöglichen, kann es von Vorteil und notwendig sein, in den keramischen Zusammensetzungen verdampfbare flüssige Dispergiermittel mit zu verwenden. Als flüssige Dispergiermittel eignen sich neben Wasser beispielsweise zahlreiche organische Verbindungen, Drucköle, deren Viskosität entsprechend der Auftragstechnik variieren kann, sowie wasserverträgliche Druckmedien, insbesondere Polyvinylalkohole.

Die keramischen Zusammensetzungen gemäß der Erfindung können außer durch unmittelbares Sintern in einem Tiegel, wie oben bereits beschrieben, auch in Form von mit den verdampfbaren Dispergiermitteln angeteigten Pasten zur Herstellung von Formteilen verwendet werden, die nach dem Brennen leitend sind und eingestellte, reproduzierbare Widerstandswerte aufweisen. Das Aufbringen der keramischen Zusammensetzungen in Form einer Suspension in den verdampfbaren Dispergiermitteln kann ganz- oder teilflächig auf den isolierenden Trägern erfolgen, auf denen dann nach dem Brennen bei Temperaturen, wie sie für Keramik oder Email üblich sind, entweder eine ganzflächige leitende Schicht oder aber beliebig geformte Leiterbahnen vorliegen, die ebenfalls eingestellte reproduzierbare Widerstandswerte aufweisen. Die Schichtdicke kann bis 1,0 mm betragen, liegt also im Bereich der für keramische Glasuren üblichen Schichtdicken, und wird je nach gewünschtem Flächenwiderstand gewählt. Dieser ist beispielsweise bei 0,1 mm Schichtdicke besonders hoch und nimmt dann mit zunehmender Schichtdicke ab.

Anders als bei den mit Edelmetallen gefüllten metallkeramischen Leitern der Dickschichttechnik kann es erforderlich sein, die unter Verwendung der keramischen Zusammensetzungen gemäß der Erfindung erhaltenen siliciumhaltigen Leiter vor ihrer Inbetriebnahme zu formieren, indem der Leiter kurzfristig mit einem Strom belastet wird, der deutlich höher ist als der später im Dauerbetrieb durch den Leiter fließende Strom. Hierbei werden die eventuell auf der Oberfläche der Siliciumpartikel noch vorhandenen, den Stromfluß hemmenden Oxidhäutchen dauerhaft durchschlagen, womit ein ungehinderter Stromfluß von Siliciumkorn zu Siliciumkorn durch deren gemeinsame Berührungsfläche stattfinden kann. Die Formierung kann beispielsweise durch Kondensatorentladung erfolgen.

Patentansprüche

1. Keramische Zusammensetzungen, bestehend im wesentlichen aus einer gemahlenen Glasfritte einerseits und Metallteilchen andererseits, die gegebenenfalls in einem verdampfbaren flüssigen Dispergiermittel suspendiert oder pastenförmig angeteigt sind bzw. werden, dadurch gekennzeichnet, daß die Glasfritte einen Gehalt an für die Dotierung von Silicium geeigneten Elementen in Mengen von 2 bis 30 Gew.-%, berechnet als Oxide und bezogen auf die in der Fritte insgesamt vorliegenden Oxide, aufweist, und daß die Metallteilchen aus technisch reinem Siliciumpulver bestehen.

2. Keramische Zusammensetzungen nach Anspruch 1, dadurch gekennzeichnet, daß die Glasfritte Bor und/oder Phosphor enthält.

3. Keramische Zusammensetzungen nach Anspruch 1 oder 2, dadurch gekennzeichnet, daß sie aus 20 bis 50 Gew.-% Glasfritte und Rest Siliciumpulver bestehen, jeweils bezogen auf die Gesamtfeststoffe.

4. Keramische Zusammensetzungen nach Anspruch 1 bis 3, dadurch gekennzeichnet, daß das Siliciumpulver ein Kornspektrum von 0 bis 120 μm aufweist.

5. Keramische Zusammensetzungen nach Anspruch 1 bis 4, dadurch gekennzeichnet, daß sie auf Kosten des Siliciumpulvers zusätzlich bis zu 40 Gew.-%,

vorzugsweise 5 bis 30 Gew.-%, eines die Viskosität der Glasfritte steuernden Schwebemittels aufweisen.

6. Keramische Zusammensetzungen nach Anspruch 1 bis 5, dadurch gekennzeichnet, daß sie 30 Gew.-% borhaltige Glasfritte, 10 bis 25 Gew.-% Schwebemittel und 45 bis 60 Gew.-% Siliciumpulver enthalten.

7. Keramische Zusammensetzungen nach Anspruch 1 bis 6, dadurch gekennzeichnet, daß sie 30 Gew.-% borhaltige Glasfritte, 30 bis 40 Gew.-% Schwebemittel und Rest Siliciumpulver enthalten.

8. Keramische Zusammensetzungen nach Anspruch 1 bis 7, dadurch gekennzeichnet, daß als gegebenenfalls vorhandene verdampfbare flüssige Dispergiermittel Wasser, organische Verbindungen, Drucköle auch unterschiedlicher Viskosität und/oder wasserverträgliche Druckmedien verwendet sind.

9. Keramische Zusammensetzungen nach Anspruch 8, dadurch gekennzeichnet, daß als verdampfbare flüssige Dispergiermittel Polyvinylalkohole verwendet sind.

10. Verwendung der keramischen Zusammensetzungen nach Anspruch 1 bis 9 in Form von mit verdampfbaren Dispergiermitteln angeteigten Pasten zur Herstellung von nach dem Brennen bei in der Keramikindustrie üblichen Temperaturen leitenden, eingestellte Widerstandswerte aufweisenden, gegebenenfalls pulverisierbaren Körpern.

0198150

11. Verwendung der keramischen Zusammensetzungen nach Anspruch 1 bis 9 in Form von durch Suspendieren in verdampfbaren Dispergiermitteln erhaltenen Beschichtungs- bzw. Dekorationswerkstoffen bzw. -glasuren zur Herstellung von nach dem Brennen bei für Keramik oder Email üblichen Temperaturen leitenden, eingestellte Widerstandswerte aufweisenden und mit dem Träger aus Glas, Keramik oder isoliertem Metall eine untrennbare Einheit bildenden, ganz- oder teilflächigen Schichten.

12. Verwendung der keramischen Zusammensetzungen nach Anspruch 1 bis 7 zur Herstellung von nach dem Sintern leitenden, eingestellte Widerstandswerte aufweisenden und gegebenenfalls pulverisierbaren Körpern.

Europäisches
Patentamt

**EUROPÄISCHER RECHERCHENBERICHT**

Nummer der Anmeldung

EP 86 10 0494

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 2, Nr. 75 (E-78)[2991], 14. Juni 1978; & JP - A - 53 040 898 (MATSUSHITA DENKI SANGYO K.K.) 13.04.1978 | 1,3 | C 03 C 8/14 H 01 C 7/00 |
| | --- | | |
| A | PATENT ABSTRACTS OF JAPAN, Band 2, Nr. 75 (E-78)[2991]; & JP - A - 53 040 897 (MATSUSHITA DENKI SANGYO K.K.) 13.04.2978 | 1-3 | |
| | --- | | |
| A | PATENT ABSTRACTS OF JAPAN, Band 1, Nr. 86 (E-77)[1968], 11. August 1977; & JP - A - 52 022 794 (MATSUSHITA DENKI SANGYO K.K.) 21.02.1977 | 1 | |
| | --- | | RECHERCHIERTE SACHGEBIETE (Int. Cl.4) |
| A | PATENT ABSTRACTS OF JAPAN, Band 1, Nr. 114 (E-77)[4302], 30. September 1977; & JP - A - 52 046 499 (MATSUSHITA DENKI SANGYO K.K.) 13.04.1977 | 1 | C 03 C 4/00 C 03 C 8/00 C 03 C 14/00 H 01 C 7/00 H 01 C 8/00 |
| | --- | | |
| A | CHEMICAL ABSTRACTS, Band 100, Nr. 16, 16. April 1984, Seite 634, Spalte 1, Abstract Nr. 130917y, Columbus, Ohio, US; & JP - A - 58 197 826 (HITACHI LTD.) 17.11.1983 | 1,2 | |
| | ---     -/- | | |

Der vorliegende Recherchenbericht wurde für alle Patentansprüche erstellt.

| Recherchenort BERLIN | Abschlußdatum der Recherche 18-04-1986 | Prüfer STROUD J.G. |
|---|---|---|

**Europäisches Patentamt**

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | CHEMICAL ABSTRACTS, Band 100, Nr. 14, 2. April 1984, Seite 646, Spalte 2, Abstract Nr. 113405n, Columbus, Ohio, US; & JP - A - 58 194 356 (NIPPON ELECTRIC CO., LTD.) 12.11.1983 --- | 1,2 | |
| A | US-A-3 542 609 (H.M. BOHME et al.) * Zusammenfassung * --- | 1,2 | |
| A | US-A-3 986 905 (P.M. GARAVAGLIA) * Spalte 1, Zeile 29 - Spalte 2, Zeile 47 * --- | 1,2 | |
| P,X | GB-A-2 152 027 (GROUP SERVICES LTD.) * Ansprüche 1,4-13; Seite 9, Zeilen 36-43; Beispiele * | 1 | RECHERCHIERTE SACHGEBIETE (Int. Cl.4) |
| P,A | * Ansprüche 5,10-12 * --- | 4,5,8 | |
| A | US-A-3 748 171 (J.E. PEELING) * Ansprüche 1,5; Tabelle VII * ----- | | |

Der vorliegende Recherchenbericht wurde für alle Patentansprüche erstellt

| Recherchenort BERLIN | Abschlußdatum der Recherche 18-04-1986 | Prüfer STROUD J.G. |
|---|---|---|

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82